(19) **Europäisches Patentamt**

**European Patent Office**

**Office européen des brevets**

(11) **EP 0 505 259 B1**

(12) **FASCICULE DE BREVET EUROPEEN**

(45) Date de publication et mention
de la délivrance du brevet:
**23.02.2000 Bulletin 2000/08**

(51) Int. Cl.[7]: **H01L 39/24**, H01L 39/22,
H01L 39/12

(21) Numéro de dépôt: **92400697.6**

(22) Date de dépôt: **16.03.1992**

(54) **Transistor supra-conducteur à effet de champ et procédé de fabrication d'une structure multicouche telle que celle utlisée dans le transistor**

Supraleitender Feldeffekttransistor und Verfahren zur Herstellung einer Mehrfachlagenstruktur für diesen Transistor

Superconducting field effect transistor and method for making a multilayer structure used in that transistor

(84) Etats contractants désignés:
**DE ES FR GB IT SE**

(30) Priorité: **22.03.1991 FR 9103529**

(43) Date de publication de la demande:
**23.09.1992 Bulletin 1992/39**

(73) Titulaire: **BULL S.A.**
**92800 Puteaux (FR)**

(72) Inventeurs:
• **Bernstein, Pierre**
  **F-75116 Paris (FR)**
• **Bok, Julien**
  **F-75116 Paris (FR)**

(74) Mandataire: **Denis, Hervé et al**
**Direction de la Propriété Intellectuelle BULL SA,**
**Poste courrier: LV59C18,**
**68 route de Versailles**
**78430 Louveciennes (FR)**

(56) Documents cités:
**EP-A- 0 324 044**       **EP-A- 0 494 580**

• **WORKSHOP ON HIGH TEMPERATURE SUPERCONDUCTING ELECTRON DEVICES 7 Juin 1989, SHIKABE, JAPAN pages 281 - 284 D.F.Moore et al 'Superconducting Thin Films for Device Applications'**
• **PATENT ABSTRACTS OF JAPAN vol. 12, no. 423 (E-680)9 Novembre 1988 & JP-A-63 160273 ( FUJITSU )**
• **APPLIED PHYSICS LETTERS vol. 55, no. 19, 6 Novembre 1989, NEW YORK, US pages 2032 - 2034 Rogers C.T. et al 'Fabrication of heteroepitaxial YBa2Cu3O7-x-PrBa2Cu3O7-x-YBa2-Cu3O7-x Josephson devices grown by laser deposition'**
• **APPLIED PHYSICS LETTERS vol. 58, no. 3, 21 Janvier 1991, NEW YORK, US pages 298 - 300 Obara, H. et al 'Preparation of PrBa2Cu3Oy and PrBa2Cu3Oy/YBa2Cu3Oy epitaxial films'**
• **PHYSICAL REVIEW LETTERS vol. 64, no. 7, 12 Février 1990, NEW YORK, US pages 804 - 807 New York, US 'YBa2Cu3O7/PrBa2Cu3O7 Superlattices: Properties of Ultrathin Superconducting Layers Separated by Insulating Layers'**
• **PATENT ABSTRACTS OF JAPAN vol. 14, no. 229 (E-0928)15 Mai 1990 & JP-A-2 060176 ( JAPAN AVIATION ELECTRON INDUSTRY )**

**Description**

L'invention se rapporte à un transistor supraconducteur à effet de champ et à un procédé de fabrication d'une structure multicouche telle que celle utilisée dans le transistor.

On appelle ordinairement dans ce domaine un matériau HTSC (High Temperature Super-Conductor) un matériau supraconducteur à haute température critique, couramment un oxyde. Depuis l'apparition des oxydes HTSC en 1986, des travaux ont été menés pour étudier leur emploi éventuel dans le domaine de l'électronique. La supraconductivité ouvrait en effet la perspective de réaliser des dispositifs rapides à très faible consommation d'énergie et fonctionnant à la température de l'azote liquide. Différents transistors supraconducteurs à effet de champ ont déjà été présentés. On distingue actuellement deux principes de fonctionnement des transistors à effet de champ (FET) supraconducteurs.

Le premier principe a été proposé pour la première fois par T.D. Clark dans sa thèse soutenue à l'université de Londres en 1971 (non publiée). Le transistor supraconducteur est semblable à un transistor à effet de champ classique et comprend, à la surface d'un substrat semiconducteur de InSb, de InAs ou de InAsGa par exemple, une couche semiconductrice épitaxiale dopée de type de conductivite n servant de support à des électrodes supraconductrices de source et de drain délimitant dans la couche épitaxiale un canal recouvert par une couche d'isolation de grille supportant l'électrode de grille. La distance source-drain, qui définit la longueur électrique du canal du transistor, correspond sensiblement à la longueur de cohérence du matériau supraconducteur de façon à permettre la diffusion de paires de Cooper entre la source et le drain par effet Josephson. Il est connu que le courant supraconducteur maximal $I_o$ pouvant traverser une jonction Josephson est inversement proportionnel à la résistance $R_n$ à l'état normal de la barrière de la jonction. Le canal joue le rôle de cette barrière. La couche épitaxiale de canal laisse passer par effet de proximité des porteurs de charge supraconducteurs. La nature semiconductrice du canal permet, en appliquant une tension de commande sur la grille, de moduler le nombre de porteurs de charge présents et de faire varier en conséquence la valeur de la résistance $R_n$. Si un courant I constant et supérieur à $I_o$ circule entre la source et le drain, la tension VDS entre ces deux électrodes satisfait à la relation $V_{DS} = R_n(I^2 - I_o^2)^{1/2}$. Le dispositif présente donc bien un effet transistor. Sa construction est bien adaptée aux matériaux supraconducteurs classiques à basse température tels que les composés au niobium, car leur longueur de cohérence est en général relativement grande (de l'ordre de 100nm). Les matériaux HTSC présentent par contre une longueur de cohérence beaucoup plus faible (de l'ordre de quelques nanomètres), qui rend alors la réalisation du transistor très difficile.

Le deuxième principe de fonctionnement d'un transistor supraconducteur à effet de champ est illustré par exemple dans la demande de brevet japonais publiée sous le n° 01-155671. Le transistor qui y est décrit est formé à partir d'un substrat métallique. Une face du substrat porte une structure multicouche faite d'une couche diélectrique recouverte d'une couche supraconductrice définissant un canal entre les électrodes de source et de drain. L'autre face du substrat porte une électrode de commande. La couche diélectrique donnée à titre d'exemple était faite de $SrTiO_3$ orienté (100) et épaisse de 200 nm, ou de MgO épais de 150 nm. La couche supraconductrice appartenait à la famille RE-Ba-Cu-O et était épaisse de 60 nm. En fonctionnement, le nombre des porteurs de charge qui transitent dans le canal supraconducteur est ajusté par le champ électrique produit par la tension de commande. Ce champ électrique provoque une accumulation de charges à l'interface de la couche supraconductrice avec la couche diélectrique et détruit des paires électroniques dans la couche supraconductrice. Cette destruction supprime la supraconductivité de la couche supraconductrice et réduit donc le courant qui la traverse. Les inventeurs assurent avoir observé un tel effet dans un transistor incluant une couche supraconductrice de $YBa_2Cu_3O_{6+x}$ séparée, par l'intermédiaire d'une couche diélectrique $SrTiO_3$ épaisse de 200 nm, d'une électrode de commande portée à une tension de 450 V.

Ce principe de fonctionnement est intéressant, mais le transistor proposé présente trois inconvénients majeurs. D'abord, la tension de commande à appliquer sur le substrat du transistor pour obtenir l'effet de champ désiré est très élevée (450 volts, dans l'exemple cité), incompatible avec les applications courantes des transistors. Ensuite, le document japonais signale l'observation d'un courant entre la source et le drain, sans en indiquer la valeur. En réalité, ce courant a une très faible intensité. Pourtant, la couche supraconductrice véhiculant ce courant avait une épaisseur relativement élevée (60 nm), de même que l'épaisseur de la couche diélectrique sous-jacente (150 ou 200 nm selon le matériau utilisé). Une diminution de l'épaisseur de la couche supraconductrice laisse prévoir une diminution du courant, tandis que l'expérience révèle qu'une augmentation de l'épaisseur ne produit pas un courant sensiblement plus important. Enfin, le document japonais précité ne donne aucune indication sur les paramètres déterminant la variation de la valeur de l'effet de champ produit par le transistor antérieur. Il ne permet donc pas d'optimiser l'effet de champ. Afin d'accroître l'effet de champ du transistor antérieur, l'homme du métier pourrait penser à ajuster le nombre p de porteurs de charge dans le matériau HTSC. La concentration en porteurs de charge peut en effet être réglée en agissant sur la concentration en oxygène dans le matériau HTSC. Cependant, la concentration en oxygène est difficile à maîtriser.

D'autres transistors supraconducteurs sont connus. Le document publié dans Patent Abstracts of Japan, vol. 12, n° 423 (E-680)9, novembre 1988, JP-A-63 160273, décrit un transistor supraconducteur bipolaire, dont la base est faite d'une structure supraconductrice multicouche composée alternativement de couches de PbTe et de SnTe à la fois superconductrices et semi-conductrices de type N, non faites d'oxyde supraconducteur et ayant une basse température critique. Le transistor fonctionne sur le principe des électrons chauds. Le document 2nd Workshop on High-Temperature Superconducting Electron Devices, 7 juin 1989, Japon, pages 281-284, D.F. Moore, "Superconducting Thin Films for Devices Applications" présente des structures de test d'effet de champ dans une couche supraconductrice par application d'une tension sur une grille isolée, formée sur la couche supraconductrice. Un transistor supraconducteur à effet de champ est décrit dans le document EP-A-0324044. Une couche supraconductrice formée sur un substrat constitue une structure de canal disposée sous une électrode de grille placée entre des électrodes de source et de drain. La grille peut être isolée ou non de la couche supraconductrice. Les électrodes de source et de drain sont respectivement placées sur les faces latérales opposées de la couche supraconductrice. Le principe de fonctionnement consiste à donner à la couche supraconductrice une épaisseur telle que, en appliquant un signal de commande suffisamment élevé sur la grille, la région supraconductrice sous la grille soit complètement appauvrie en porteurs de charge. Pour une couche supraconductrice de $YBa_2Cu_3O_7$, l'épaisseur n'est que de 1 nm. Enfin, le document publié dans Patent Abstracts of Japan, vol. 14, n° 299 (E-0928), 15 mai 1990, JP-A-2060176, décrit un transistor à effet Aharonov-Bohm. Il inclut une structure multicouche faite de deux paires de couches, chaque paire comprenant une couche supraconductrice et une couche tampon semi-conductrice ou isolante. Les deux paires sont séparées par une couche isolante, adjacente aux deux couches supraconductrices de la structure. L'électrode de grille est disposée sur la couche non supraconductrice de la paire supérieure, tandis que les électrodes de source et de drain sont disposées latéralement à la structure et sont en contact avec les couches de la structure.

L'invention présente un transistor supraconducteur à effet de champ capable de conduire des courants importants, de quelques mA par exemple, sous une faible tension drain-source de l'ordre de 10 mV par exemple, et sous la commande d'une tension faible, de quelques volts seulement. L'invention présente en outre un procédé d'ajustement du nombre p de porteurs libres pour l'optimisation de l'effet de champ.

Un transistor supraconducteur à effet de champ conforme à l'invention a les caractéristiques définies dans la revendication 1.

L'invention se rapporte aussi à un procédé de fabrication d'une structure multicouche utilisée dans le transistor conforme à l'invention, le procédé ayant les caractéristiques définies dans la revendication 15.

Les caractéristiques et avantages de l'invention ressortent de la description qui suit, donnée à titre d'exemple et faite en référence aux dessins annexés.

Dans les dessins :

- la figure 1 illustre schématiquement la structure vue en coupe transversale partielle d'un substrat portant un transistor supraconducteur à effet de champ conforme à l'invention ;

- les figures 2A, 2B et 2C sont des graphes illustrant les variations de la température critique $T_c$ en kelvins avec le nombre p de porteurs de charge libres positifs par atome de cuivre dans respectivement les composés $La_{2-x}Sr_xCuO_4$, $YBa_2Cu_3O_7$ et $Bi_2Sr_2CaCu_2O_x$ ; et

- la figure 3 est un graphe illustrant la variation de la température critique $T_c$ en kelvins pour laquelle a été obtenu 10% de la résistance à l'état normal d'un ensemble de couches alternées de $YBa_2Cu_3O_7$ d'épaisseur constante de 1,2 nm et de $PrBa_2Cu_3O_7$ ayant chacune l'épaisseur $\underline{w}$ indiquée en abscisses.

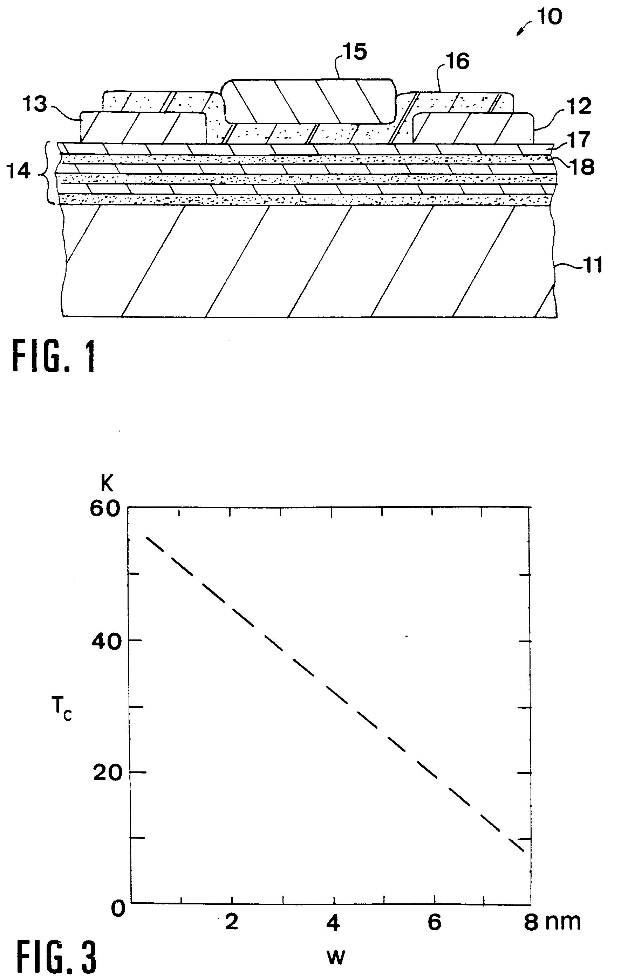

Le transistor supraconducteur à effet de champ 10 conforme a l'invention, représenté sur la figure 1, a une structure à grille isolée du type MISFET (Metal Insulator Semiconductor Field Effect Transistor), par exemple de type MOS (Métal-Oxyde-Semiconducteur). Il est formé sur la surface d'un substrat 11 et comprend une électrode de source 12 et une électrode de drain 13 reposant sur une structure constituant un canal de courant 14 entre ces deux électrodes. Le canal 14 porte une électrode de grille 15 par l'intermédiaire d'un film d'isolation de grille 16. Les rapports des dimensions représentées sur la figure 1 ont été volontairement modifiés pour la clarté des dessins. Dans l'exemple préféré qui est illustré dans la figure 1, le transistor 10 a le substrat fait de MgO, les électrodes de source et de drain 12, 13 et la grille 15 en matériau supraconducteur $YBa_2Cu_3O_7$ et le film d'isolation de grille 16 en $SiO_2$. Le canal 14 est formé d'une structure multicouche reposant sur le substrat 11. La structure de canal 14 est faite à partir d'une couche supraconductrice 17 et d'une couche non supraconductrice 18. Dans l'exemple préféré qui est illustré dans la figure 1, la paire de couches 17 et 18 est répétée trois fois dans la structure de canal 14. Dans chaque paire, la couche supraconductrice 17 est la couche supérieure.

Dans la structure de canal 14, chaque couche supraconductrice 17 a une épaisseur très faible, de l'ordre de quelques nanomètres seulement. Les inventeurs ont tenté d'expliquer cette valeur par la théorie suivante, qui donne à cette épaisseur l'ordre de grandeur de la longueur de Debye $L_D$.

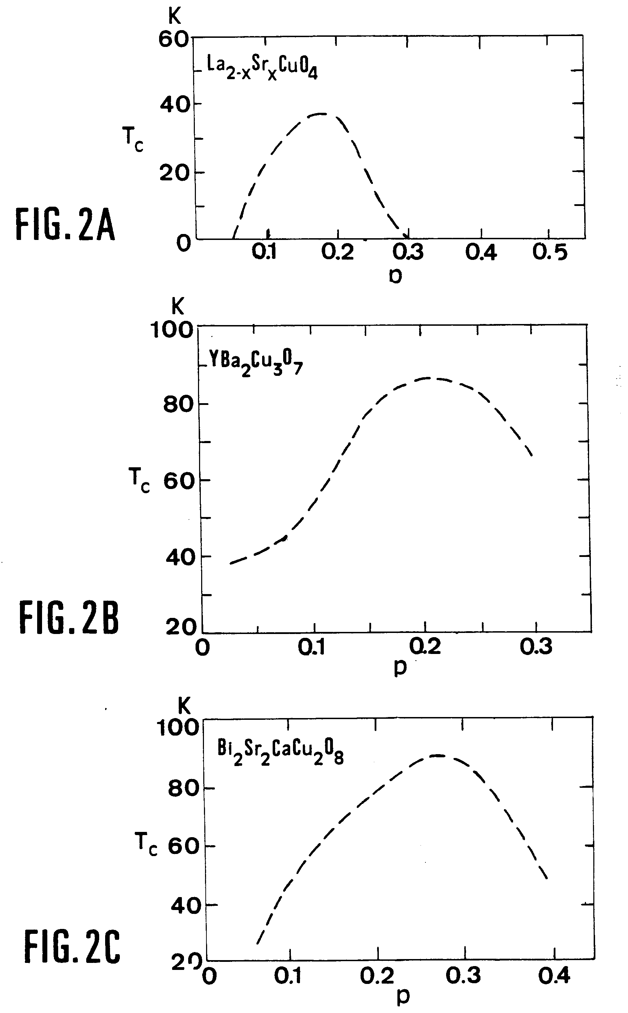

Les nouveaux oxydes supraconducteurs doivent leur supraconductivité à l'existence dans leur maille élémentaire de plans incluant des atomes Cu et O. Les figures 2A, 2B et 2C annexées se rapportent respectivement aux oxydes supraconducteurs $La_{2-x}Sr_xCuO_4$, $YBa_2Cu_3O_7$ et $Bi_2Sr_2CaCu_2O_8$ et font ressortir que la température critique $T_c$ dépend très fortement du nombre p de porteurs de charge libres positifs par atome de cuivre dans les composés respectifs et, par conséquent, de la charge des groupes Cu-O des plans de leur maille. Par exemple, dans le cas de $YBa_2Cu_3O_7$ (figure 2B), la température critique $T_c$ passe de 80K à 70K quand le nombre p décroît de 0,16 à 0,13 porteurs de charge par groupe de Cu-O. La transition entre l'état supraconducteur et l'état normal, provoquée par l'application d'un champ électrique, est due au fait que la température critique $T_c$ de la zone appauvrie en porteurs de charge devient inférieure à sa température de fonctionnement à champ nul. Dans ces conditions, la profondeur de pénétration du champ électrique dans le canal pourrait s'apprécier grossièrement de la manière suivante. En assimilant les propriétés du matériau HTSC d'une couche supraconductrice à celles d'un matériau de type métallique, la profondeur de pénétration $\underline{z}$ d'un champ électrique E dans un tel matériau suit une loi exponentielle décroissante exprimée par la formule $E = A\,e^{-z/LD}$, où A est un coefficient de proportionnalité et $L_D$ la longueur de Debye. La longueur de Debye $L_D$ dans un modèle simple de Thomas-Fermi vérifie la formule : $L_D = n_o e^2/EE_o$, où $n_o$ est la densité d'états au niveau de Fermi, e est la charge électronique, et $E_o$ et E sont les permittivités respectives du vide et du matériau HTSC utilisé. Dans le cas de $YBa_2Cu_3O_7$, si le matériau HTSC est légèrement déficitaire en oxygène, on peut avoir environ $n_o = 5.10^{20}$ cm$^{-3}$.eV$^{-1}$ et $L_D = 2,5$ nm. Par conséquent, selon cette théorie, la densité de porteurs de charge ne peut varier que sur une profondeur maximale de quelques nanomètres. Cette théorie peut donc justifier en première approximation l'emploi d'une faible épaisseur de matériau HTSC dans le canal du transistor conforme à l'invention. D'après cette théorie, l'épaisseur serait de l'ordre de grandeur de la longueur de Debye, et si le matériau HTSC est plus épais, la partie du canal non soumise au champ électrique restera supraconductrice et masquera l'effet recherché.

L'avantage constaté est effectivement dans l'application d'une faible valeur de la tension de commande. Mais l'inconvénient demeure de n'obtenir qu'un très faible courant avec l'emploi d'une structure de canal 14 ayant une seule paire de couches 17, 18, dont la couche supraconductrice 17 a la faible épaisseur précitée.

Pour accroître l'intensité du courant, la structure de canal 14 du transistor représenté sur la figure 1 a été réalisée en s'inspirant de l'article de J.M. Triscone et al dans la revue Physical Review Letters, Vol. 64, No 7, Feb. 12, 1990, pages 804-807, intitulé《 $YBa_2Cu_3O_7$/$PrBa_2Cu_3O_7$ Superlattices : Properties of Ultrathin Superconducting Layers Separated by Insulating Layers 》. La structure décrite est formée d'un nombre entier non nul de paires superposées, composées chacune d'une couche supraconductrice supérieure 17 de $YBa_2Cu_3O_7$ et d'une couche diélectrique 18 de $PrBa_2Cu_3O_7$. Conformément à l'invention, la couche supraconductrice 17 de chaque paire avait une épaisseur de quelques nanomètres, correspondant environ à la longueur de Debye $L_D$. Le transistor 10 pourvu de cette structure multicouche de canal 14 dans le transistor 10 permet de faire passer un courant source-drain plus important avec une tension de commande faible.

Dans l'article précité, d'autre part, les auteurs ont observé, pour une épaisseur de $YBa_2Cu_3O_7$ inchangée, les variations de la température critique $T_c$ en fonction de l'épaisseur $\underline{w}$ de chaque couche adjacente de $PrBa_2Cu_3O_7$ et ont tracé la courbe représentée sur la figure 3. Les auteurs ont interprété cette courbe en la reliant à un couplage Josephson entre couches supraconductrices de $YBa_2Cu_3O_7$ de la structure.

Selon les inventeurs, elle serait plutôt due à un transfert des porteurs de charge des couches supraconductrices vers les couches diélectriques de la structure. Les inventeurs en ont ainsi déduit un procédé très intéressant d'optimisation des transferts de charges entre les couches adjacentes de chaque paire. Selon ce procédé, on considère les couches supraconductrices comme des donneurs de charges et les couches non supraconductrices adjacentes comme des récepteurs de ces charges. Pour optimiser le nombre de porteurs de charge dans une couche supraconductrice de la structure multicouche, le procédé consiste à optimiser les transferts de charges entre les couches de chaque paire.

L'ampleur de ces transferts de charges est alors déterminée par les épaisseurs des couches de chaque paire. Ceci corrobore l'avantage observé d'une faible épaisseur de chaque couche supraconductrice. Selon le procédé, le fonctionnement du transistor 10 est optimal quand le nombre p de porteurs de charge de la couche supraconductrice à champ électrique nul est ajusté de façon que la température critique $T_c$ soit très sensible aux variations du nombre p qui sont induites quand un champ électrique est appliqué dans le canal. Cet ajustement, fait par exemple en référence à la courbe représentée sur la figure 2B relative à $YBa_2Cu_3O_7$, doit donc se faire sur la partie d'extrémité à forte pente de la courbe. Le nombre p est ainsi amené dans une partie la plus favorable à la production d'un effet de champ important. On a vu précédemment que l'étude théorique explicative faite par les inventeurs conduit à donner à chaque couche supraconductrice 17 une épaisseur de l'ordre de grandeur de la longueur de Debye $L_D$, de l'ordre de quelques nanomètres. L'épaisseur de chaque couche non supraconductrice est déterminée expérimentalement de façon à obtenir une concentration p de porteurs de charge pour laquelle le rapport $dT_c/dp$ soit optimal. Ceci peut être fait en référence à une courbe du type de celle représentee sur la figure 3. D'une manière générale, dans la structure multicouche 14 ayant des couches supraconductrices 17 d'épaisseur prédéterminée et des couches non supraconductrices 18 d'épaisseur $\underline{w}$, cette courbe de référence illustre la variation de la température critique $T_c$ en Kelvins qui permet d'obtenir, en fonction de l'épaisseur $\underline{w}$ de chaque couche non supraconductrice 18, un pourcentage prédéterminé de la résistance à l'état normal de chaque couche 18 lorsque les couches supraconductrices 18 ont une épaisseur fixe prédéterminée. En pratique, la couche diélectrique 18 a aussi une épaisseur de l'ordre de la longueur de Debye $L_D$. Avantageusement, chacune de ces deux couches est faite d'au moins une maille cristalline superposée, le nombre de ces mailles correspondant étant fixé de façon à obtenir l'épaisseur désirée de chacune des couches. Pour assurer l'optimisation du transfert de charges entre couches de chaque paire, leur interface doit être continûment de bonne qualité. Par exemple, les couches de la structure de canal 14 ont été formées par croissance épitaxiale pour avoir l'interface désirée. Dans ce cas, le choix des matériaux des couches appairées de la structure doit assurer leur compatibilité avec la croissance épitaxiale. Cette condition est satisfaite avec l'association $YBa_2Cu_3O_7/PrBa_2Cu_3O_7$ décrite précédemment.

D'une manière générale, on peut appliquer la méthode à d'autres matériaux que le $PrBa_2Cu_3O_7$ dans le cas où on utilise $YBa_2Cu_3O_7$, et à d'autres matériaux supraconducteurs que $YBa_2Cu_3O_7$. En outre, les couches non supraconductrices de la structure de canal 14 peuvent être des couches diélectriques comme celles précitées, ou être des couches semiconductrices dopées ou non, ou encore des couches faites en un matériau métallique. Par exemple, un mode réalisation préféré de l'invention utilise le $BiSr_2(Ca_{1-x}Y_x)\,Cu_2O_8$ comme matériau semiconducteur avec $x = 0,35$ et ce même matériau avec $x = 0,15$ comme matériau HTSC compatible avec la croissance épitaxiale. Il serait aussi possible d'associer par exemple des couches à base de thallium au lieu du bismuth précité.

A la limite, on a vu qu'un transistor 10 conforme à l'invention pourrait fonctionner avec une seule paire de couches 17, 18 dans la structure de canal 14. Cependant, cette structure ne pourrait que faire passer un courant maximal très faible. L'empilement de plusieurs couches supraconductrices et non supraconductrices, entre lesquelles se produit un transfert de charges et dont l'épaisseur est de quelques mailles élémentaires (donc de l'ordre de grandeur de LD), atténue fortement l'effet d'écran au champ électrique appliqué. Cette structure permet alors le passage d'un courant d'une intensité totale proportionnelle au nombre de paires de couches sous une faible tension drain-source et sous l'action d'une tension de grille également faible. Par exemple, une structure de canal 14 formée de trois paires de couches faites de la façon décrite précédemment peut passer un courant de quelques mA avec une tension drain-source de l'ordre de 10mV et sous l'action d'une tension de grille de quelques volts seulement.

En outre, la structure multicouche du canal 14 est électriquement équivalente à la mise en série de capacités électriques. Il s'ensuit que la capacité totale d'entrée d'un transistor 10 conforme à l'invention est faible par rapport à un transistor dont le canal serait réduit à une seule couche supraconductrice 17. Un des avantages de cette faible capacité est d'accroître la bande passante du transistor jusqu'à des fréquences très élevées.

Par ailleurs, les valeurs élevées du champ électrique nécessaire pour obtenir l'effet désiré peuvent être plus facilement obtenues si le film d'isolation de grille 16 présente une forte permittivité diélectrique. Cette condition est donc contraire à celle relative aux transistors MOS non supraconducteurs.

Dans le transistor 10 conforme à l'invention, les électrodes de source et de drain ne doivent pas être nécessairement supraconductrices. Elles peuvent être faites d'un matériau métallique ou d'un matériau semiconducteur dopé. Il en est de même pour l'électrode de grille 15. Cependant, ces matériaux n'offrent pas les avantages de conduction électrique des matériaux HTSC.

Enfin, il ressort clairement à l'homme de métier que l'invention qui a été décrite en référence à un transistor de type MOSFET peut s'appliquer aussi à un transistor supraconducteur à effet de champ de type MESFET (Metal Semiconductor Field Effect Transistor) à barrière Schottky, dont l'électrode de grille 15 est disposée sur la structure multicouche de canal 14 sans l'intermédiare du film d'isolation de grille 16.

## Revendications

1. Transistor supraconducteur à effet de champ (10) du type à grille isolée (MISFET) ou du type à grille non isolée (MESFET) à barrière Schottky, comprenant un substrat (11), une structure multicouche (14) définissant un canal et disposée sur le substrat, la structure comprenant au moins une paire de couches formée d'une couche supraconductrice (17) et d'une couche non supraconductrice (18), la couche supraconductrice (17) de chaque paire étant faite d'oxyde supraconducteur à haute température critique et ayant une épaisseur de l'ordre de grandeur de la longueur de Debye, la couche non supraconductrice (18) de chaque paire étant placée entre la couche supraconductrice (17) de la paire et le substrat (11), les couches de la structure (14) présentant des interfaces continues entre elles, la structure permettant le passage d'un courant d'une intensité totale proportionnelle au nombre de paires de couches (17, 18), et des électrodes de grille (15), de source et de drain (12, 13) disposées sur la structure multicouche (14), l'électrode de grille étant placée entre les électrodes de source et de drain et au-dessus de la couche supraconductrice supérieure de la structure.

**2.** Transistor selon la revendication 1, caractérisé en ce que la structure (14) est faite en matériaux permettant la croissance épitaxiale d'une couche sur l'autre.

**3.** Transistor selon la revendication 1 ou 2, caractérisé en ce que l'épaisseur des couches (17, 18) de chaque paire de la structure de canal (14) est ajustée de façon que la température critique $T_c$ varie fortement en fonction du nombre (p) de porteurs de charge dans la couche supraconductrice (17) en champ électrique nul et que l'épaisseur de la couche non supraconductrice (18) permette la réception optimale des porteurs de charge fournis par la couche supraconductrice.

**4.** Transistor selon la revendication 3, caractérisé en ce que l'épaisseur de chaque couche non supraconductrice (18) de la structure (14) est ajustée en référence à une courbe (fig. 3) indiquant la variation de la température critique $T_c$ permettant d'obtenir, en fonction de l'épaisseur (w) de ladite couche, un pourcentage prédéterminé de la résistance à l'état normal de ladite couche lorsque les couches supraconductrices de la structure ont une épaisseur fixe prédéterminée.

**5.** Transistor selon l'une des revendications 1 à 4, caractérisé en ce que chaque couche non supraconductrice (18) de la structure (14) a une épaisseur de l'ordre de grandeur de la longueur de Debye.

**6.** Transistor selon l'une des revendications 1 à 5, caractérisé en ce que chacune des couches (17, 18) de la structure (14) est faite d'au moins deux mailles cristallines superposées, le nombre de ces mailles correspondant sensiblement à l'épaisseur désirée de ces couches.

**7.** Transistor selon l'une des revendications 1 à 6, caractérisé en ce que la couche non supraconductrice (18) est faite en un matériau électriquement isolant.

**8.** Transistor selon l'une des revendications 1 à 6, caractérisé en ce que la couche non supraconductrice (18) est faite en un matériau semi-conducteur.

**9.** Transistor selon l'une des revendications 1 à 6, caractérisé en ce que la couche non supraconductrice

trice est faite en un matériau métallique.

**10.** Transistor selon l'une des revendications 1 à 9, caractérisé en ce que les électrodes de source et de drain (12, 13) sont faites en un matériau supraconducteur.

**11.** Transistor selon l'une des revendications 1 à 10, caractérisé en ce que l'électrode de grille (15) repose directement sur la couche supraconductrice (17).

**12.** Transistor selon l'une des revendications 1 à 10, caractérisé en ce que l'électrode de grille (15) repose sur la couche supraconductrice (17) par l'intermédiaire d'un film d'isolation de grille (16).

**13.** Transistor selon la revendication 12, caractérisé en ce que le film d'isolation de grille (16) présente une forte permittivité diélectrique.

**14.** Transistor selon l'une des revendications 1 à 13, caractérisé en ce que l'électrode de la grille (15) est faite en un matériau supraconducteur.

**15.** Procédé de fabrication d'une structure multicouche utilisée dans le transistor défini par l'une des revendications précédentes, comprenant au moins une paire de couches composées d'une couche non supraconductrice recouverte d'une couche d'oxyde supraconducteur à haute température critique, caractérisé en ce qu'il consiste à ajuster l'épaisseur des couches de chaque paire de façon que la température critique $T_c$ varie fortement en fonction du nombre (p) de porteurs de charge dans la couche supraconductrice en champ électrique nul et que l'épaisseur de la couche non supraconductrice permette la réception optimale des porteurs de charge fournis par la couche supraconductrice.

**16.** Procédé selon la revendication 15, caractérisé en ce que l'épaisseur de chaque couche non supraconductrice (18) de la structure (14) est ajustée en référence à une courbe (fig. 3) indiquant la variation de la température critique $T_c$ permettant d'obtenir, en fonction de l'épaisseur (w) de ladite couche, un pourcentage prédéterminé de la résistance à l'état normal de ladite couche lorsque les couches supraconductrices de la structure ont une épaisseur fixe prédéterminée.

**17.** Procédé selon la revendication 15 ou 16, caractérisé en ce que la structure (14) est faite en matériaux permettant la croissance épitaxiale d'une couche sur l'autre.

**18.** Procédé selon l'une des revendications 15 à 17, caractérisé en ce qu'au moins la couche supraconductrice (17) de chaque paire de couches de la structure (14) a une épaisseur de l'ordre de grandeur de la longueur de Debye.

19. Procédé selon l'une des revendications 15 à 18, caractérisé en ce que chacune des couches (17, 18) de la structure (14) est faite d'au moins deux mailles cristallines superposées, le nombre de ces mailles correspondant sensiblement à l'épaisseur désirée de ces couches.

20. Procédé selon l'une des revendications 15 à 19, caractérisé en ce que la couche non supraconductrice (18) est faite en un matériau électriquement isolant.

21. Procédé selon l'une des revendications 15 à 19, caractérisé en ce que la couche non supraconductrice (18) est faite en un matériau semi-conducteur.

22. Procédé selon l'une des revendications 15 à 19, caractérisé en ce que la couche non supraconductrice est faite en un matériau métallique.

**Claims**

1. Field-effect superconductor transistor (10) of the insulated-gate type (MISFET) or of the non-insulated gate type (MESFET) having a Schottky barrier, comprising a substrate (11), a multilayer structure (14) defining a channel and arranged on the substrate, the structure comprising at least one pair of layers formed of a superconducting layer (17) and a non-superconducting layer (18), the superconducting layer (17) of each pair being made of superconducting oxide having a high critical temperature and having a thickness of the order of magnitude of the Debye length, the non-superconducting layer (18) of each pair being placed between the superconducting layer (17) of the pair and the substrate (11), the layers of the structure (14) having interfaces that are continuous between themselves, the structure permitting the passage of a current of a total intensity proportional to the number of pairs of layers (17, 18), and gate (15), source and drain (12, 13) electrodes arranged on the multilayer structure (14), the gate electrode being placed between the source and drain electrodes and above the upper superconducting layer of the structure.

2. Transistor according to Claim 1, characterised in that the structure (14) is made of materials permitting the epitaxial growth of one layer on the other.

3. Transistor according to Claim 1 or 2, characterised in that the thickness of the layers (17, 18) of each pair in the channel structure (14) is adjusted so that the critical temperature $T_c$ varies greatly as a function of the number (p) of charge carriers in the superconducting layer (17) with zero electric field and that the thickness of the non-superconducting layer (18) permits optimum reception of the charge carriers supplied by the superconducting layer.

4. Transistor according to Claim 3, characterised in that the thickness of each non-superconducting layer (18) of the structure (14) is adjusted with reference to a curve (Fig. 3) indicating the variation in the critical temperature $T_c$ making it possible to obtain, as a function of the thickness (w) of said layer, a predetermined percentage of the resistance of said layer in the normal state when the superconducting layers of the structure have a predetermined fixed thickness.

5. Transistor according to one of Claims 1 to 4, characterised in that each non-superconducting layer (18) of the structure (14) has a thickness of the order of magnitude of the Debye length.

6. Transistor according to one of Claims 1 to 5, characterised in that each of the layers (17, 18) of the structure (14) is made of at least two superimposed crystalline lattices, the number of these lattices corresponding substantially to the desired thickness of these layers.

7. Transistor according to one of Claims 1 to 6, characterised in that the non-superconducting layer (18) is made of an electrically insulating material.

8. Transistor according to one of Claims 1 to 6, characterised in that the non-superconducting layer (18) is made of a semiconductor material.

9. Transistor according to one of Claims 1 to 6, characterised in that the non-superconducting layer is made of a metallic material.

10. Transistor according to one of Claims 1 to 9, characterised in that the source and drain electrodes (12, 13) are made of a superconducting material.

11. Transistor according to one of Claims 1 to 10, characterised in that the gate electrode (15) is located directly on the superconducting layer (17).

12. Transistor according to one of Claims 1 to 10, characterised in that the gate electrode (15) is located on the superconducting layer (17) via a gate insulation film (16).

13. Transistor according to Claim 12, characterised in that the gate insulation film (16) has a high dielectric permittivity.

**14.** Transistor according to one of Claims 1 to 13, characterised in that the gate electrode (15) is made of a superconducting material.

**15.** Method of manufacturing a multilayer structure used in the transistor defined by one of the preceding claims, comprising at least one pair of layers composed of a non-superconducting layer covered with a layer of superconducting oxide having a high critical temperature, characterised in that it consists in adjusting the thickness of the layers of each pair so that the critical temperature $T_c$ varies greatly as a function of the number (p) of charge carriers in the superconducting layer with zero electric field and that the thickness of the non-superconducting layer permits optimum reception of the charge carriers supplied by the superconducting layer.

**16.** Method according to Claim 15, characterised in that the thickness of each non-superconducting layer (18) of the structure (14) is adjusted with reference to a curve (Fig. 3) indicating the variation in the critical temperature $T_c$ making it possible to obtain, as a function of the thickness (w) of each layer, a predetermined percentage of the resistance of said layer in the normal state when the superconducting layers of the structure have a predetermined fixed thickness.

**17.** Method according to Claim 15 or 16, characterised in that the structure (14) is made of materials permitting the epitaxial growth of one layer on the other.

**18.** Method according to one of Claims 15 to 17, characterised in that at least the superconducting layer (17) of each pair of layers of the structure (14) has a thickness of the order of magnitude of the Debye length.

**19.** Method according to one of Claims 15 to 18, characterised in that each of the layers (17, 18) of the structure (14) is made of at least two superimposed crystalline lattices, the number of these lattices corresponding substantially to the desired thickness of these layers.

**20.** Method according to one of Claims 15 to 19, characterised in that the non-superconducting layer (18) is made of an electrically insulating material.

**21.** Method according to one of Claims 15 to 19, characterised in that the non-superconducting layer (18) is made of a semiconductor material.

**22.** Method according to one of Claims 15 to 19, characterised in that the non-superconducting layer is made of a metallic material.

**Patentansprüche**

**1.** Supraleitender Feldeffekt-Transistor (10) vom Typ mit isoliertem Gate (MISFET) oder vom Typ mit nicht-isoliertem Gate (MESFET) mit Schottky-Barriere, der ein Substrat (11) enthält, eine Mehrschicht-Struktur (14), die einen Kanal definiert und auf dem Substrat angeordnet ist, wobei die Struktur wenigstens ein Schichtpaar enthält, das aus einer supraleitenden Schicht (17) und aus einer nicht supraleitenden Schicht (18) gebildet ist, wobei die supraleitende Schicht (17) jedes Paares aus einem supraleitenden Oxid mit hoher kritischer Temperatur beschaffen ist und eine Dicke von der Größenordnung der Debye-Länge aufweist, wobei die nicht supraleitende Schicht (18) jedes Paares zwischen der supraleitenden Schicht (17) des Paares und dem Substrat (11) angeordnet ist, wobei die Schichten der Struktur (14) zwischen sich kontinuierliche Grenzflächen aufweisen und wobei die Struktur den Durchfluß eines Stroms einer Gesamtintensität ermöglicht, die zur Zahl der Schichtpaare (17, 18) proportional ist, sowie Gate-, Source- und Drain-Elektroden (15, 12, 13), die auf der Mehrschicht-Struktur (14) angeordnet sind, wobei die Gate-Elektrode (15) zwischen den Source- und Drain-Elektroden (12, 13) und über der obersten supraleitenden Schicht der Struktur angeordnet ist.

**2.** Transistor nach Anspruch 1, dadurch gekennzeichnet, daß die Struktur (14) aus Materialien besteht, die das epitaktische Wachstum der einen Schicht auf der anderen ermöglichen.

**3.** Transistor nach Anspruch 1 oder 2, dadurch gekennzeichnet, daß die Dicke der Schichten (17, 18) jedes Paares der Kanalstruktur (14) so abgestimmt ist, daß die kritische Temperatur $T_c$ stark in Abhängigkeit von der Zahl (p) der Ladungsträger in der supraleitenden Schicht (17) bei einem elektrischen Feld von Null variiert und daß die Dicke der nicht supraleitenden Schicht (18) die optimale Aufnahme der von der supraleitenden Schicht gelieferten Ladungsträger ermöglicht.

**4.** Transistor nach Anspruch 3, dadurch gekennzeichnet, daß die Dicke jeder nicht supraleitenden Schicht (18) der Struktur (14) in Bezug auf eine Kurve (Fig. 3), die die Veränderung der kritischen Temperatur $T_C$ beschreibt, abgestimmt ist und ermöglicht, in Abhängigkeit von der Dicke (w) der besagten Schicht, einen vorbestimmten Prozentsatz des Widerstands der besagten Schicht im Normalzustand zu erhalten, wenn die supraleitenden Schichten der Struktur eine feste vorbestimmte Dicke aufweisen.

**5.** Transistor nach einem der Ansprüche 1 bis 4, dadurch gekennzeichnet, daß jede nicht supraleitende Schicht (18) der Struktur (14) eine Dicke in der Größenordnung der Debye-Länge aufweist.

6. Transistor nach einem der Ansprüche 1 bis 5, dadurch gekennzeichnet, daß jede der Schichten (17, 18) der Struktur (14) aus wenigstens zwei übereinanderliegenden Kristallgitterzellen beschaffen ist, wobei die Zahl dieser Zellen im wesentlichen der gewünschten Dicke dieser Schichten entspricht.

7. Transistor nach einem der Ansprüche 1 bis 6, dadurch gekennzeichnet, daß die nicht supraleitende Schicht (18) aus einem elektrisch isolierenden Material besteht.

8. Transistor nach einem der Ansprüche 1 bis 6, dadurch gekennzeichnet, daß die nicht supraleitenden Schicht (18) aus einem halbleitenden Material besteht.

9. Transistor nach einem der Ansprüche 1 bis 6, dadurch gekennzeichnet, daß die nicht supraleitenden Schicht aus einem metallischen Material besteht.

10. Transistor nach einem der Ansprüche 1 bis 9, dadurch gekennzeichnet, daß die Source- und Drain-Elektroden (12, 13) aus einem supraleitenden Material besteht.

11. Transistor nach einem der Ansprüche 1 bis 10, dadurch gekennzeichnet, daß die Gate-Elektrode (15) direkt auf der supraleitenden Schicht (17) ruht.

12. Transistor nach einem der Ansprüche 1 bis 10, dadurch gekennzeichnet, daß die Gate-Elektrode (15) auf der supraleitenden Schicht (17) mittels eines Gate-Isolationsfilms (16) ruht.

13. Transistor nach Anspruch 12, dadurch gekennzeichnet, daß der Gate-Isolationsfilm (16) eine hohe dielektrische Permittivität aufweist.

14. Transistor nach einem der Ansprüche 1 bis 13, dadurch gekennzeichnet, daß die Gate-Elektrode (15) aus einem supraleitenden Material besteht.

15. Verfahren zur Herstellung einer in dem durch einen der voranstehenden Ansprüche definierten Transistor verwendeten Mehrschicht-Struktur, mit wenigstens einem Schichtpaar, das aus einer nicht supraleitenden Schicht, bedeckt von einer Schicht aus supraleitendem Oxid mit hoher kritischer Temperatur, zusammengesetzt ist, dadurch gekennzeichnet, daß es darin besteht, die Dicke der Schichten jedes Paares so abzustimmen, daß die kritische Temperatur $T_C$ stark in Abhängigkeit von der Zahl (p) der Ladungsträger in der supraleitenden Schicht bei einem elektrischen Feld von Null variiert und daß die Dicke der nicht supraleitenden Schicht die optimale Aufnahme der von der supraleitenden Schicht gelieferten Ladungsträger ermöglicht.

16. Verfahren nach Anspruch 15, dadurch gekennzeichnet, daß die Dicke jeder nicht supraleitenden Schicht (18) der Struktur (14) in Bezug auf eine Kurve (Fig. 3), die die Veränderung der kritischen Temperatur $T_C$ angibt, abgestimmt ist und ermöglicht, in Abhängigkeit der Dicke (w) der besagten Schicht einen vorbestimmten Prozentsatz des Widerstands im Normalzustand der besagten Schicht zu erhalten, wenn die supraleitenden Schichten der Struktur eine feste vorbestimmte Dicke aufweisen.

17. Verfahren nach Anspruch 15 oder 16, dadurch gekennzeichnet, daß die Struktur (14) aus Materialien besteht, die das epitaktische Wachstum der einen Schicht auf der anderen ermöglichen.

18. Verfahren nach einem der Ansprüche 15 bis 17, dadurch gekennzeichnet, daß wenigstens die supraleitende Schicht (17) jedes Schichtpaares der Struktur (14) eine Dicke in der Größenordnung der Debye-Länge aufweist.

19. Verfahren nach einem der Ansprüche 15 bis 18, dadurch gekennzeichnet, daß jede der Schichten (17, 18) der Struktur (14) aus wenigstens zwei übereinanderliegenden Kristallgitterzellen beschaffen ist, wobei die Zahl dieser Zellen im wesentlichen der gewünschten Dicke dieser Schichten entspricht.

20. Verfahren nach einem der Ansprüche 15 bis 19, dadurch gekennzeichnet, daß die nicht supraleitenden Schicht (18) aus einem elektrisch isolierenden Material besteht.

21. Verfahren nach einem der Ansprüche 15 bis 19, dadurch gekennzeichnet, daß die nicht supraleitenden Schicht (18) aus einem halbleitenden Material besteht.

22. Verfahren nach einem der Ansprüche 15 bis 19, dadurch gekennzeichnet, daß die nicht supraleitenden Schicht aus einem metallischen Material besteht.

FIG. 1

FIG. 3

FIG.2A

FIG.2B

FIG.2C